# EUROPÄISCHE PATENTSCHRIFT

(11) **EP 2 454 762 B1**
(45) Veröffentlichungstag und Bekanntmachung des Hinweises auf die Patenterteilung: **05.07.2017**
(21) Anmeldenummer: 10737530.5
(22) Anmeldetag: 16.07.2010
(51) Int. Cl.: H01L 33/38, H01L 33/46

(54) **P-KONTAKT UND LEUCHTDIODE FÜR DEN ULTRAVIOLETTEN SPEKTRALBEREICH**
P-CONTACT AND LIGHT-EMITTING DIODE FOR THE ULTRAVIOLET SPECTRAL RANGE
CONTACT P ET DIODE ÉLECTROLUMINESCENTE POUR LE DOMAINE SPECTRAL ULTRAVIOLET

(30) Priorität: 17.07.2009 DE 102009034359
(43) Veröffentlichungstag der Anmeldung: 23.05.2012
(73) Patentinhaber: Forschungsverbund Berlin E.V., 12489 Berlin (DE)
(72) Erfinder: KNEISSL, Michael, 10435 Berlin (DE); WEYERS, Markus, 15745 Wildau (DE); EINFELDT, Sven, 12623 Berlin (DE); RODRIGUEZ, Hernan, 11115 Bogota (CO)
(74) Vertreter: Gulde & Partner
(86) Internationale Anmeldenummer: PCT/EP2010/060333
(87) Internationale Veröffentlichungsnummer: WO 2011/006995

(56) Entgegenhaltungen:
- EP-A2- 0 880 181
- DE-A1- 10 244 986
- DE-C1- 19 954 319
- JP-A- 2007 324 411
- US-A1- 2005 087 755
- US-A1- 2008 246 047
- US-A1- 2010 140 637

## Beschreibung

Weltweit gibt es starke Aktivitäten zur Entwicklung von Leuchtdioden für den ultravioletten Spektralbereich (UV-LED), da sie Anwendungen in vielen Bereichen ermöglichen. Dazu zählen beispielsweise die Entkeimung (z.B. von Trinkwasser, Abwasser, Prozesswasser), Desinfektion von Lebensmitteln, Medizintechnik (z.B. Dermatologie, Lichttherapie), Bioanalytik (z.B. Fluoreszenzmikroskopie), Sensorik (z.B. Messung von Stickoxiden, Blankophormessung), Oberflächenpolymerisation (z.B. Druckfarben, Lacke, Epoxydharze) und der Einsatz als Strahlquellen für die optische Freiraumkommunikation. Die erforderlichen Emissionswellenlängen und - intensitäten hängen stark von der Anwendung ab und variieren über einen weiten Spektralbereich. Eine der Herausforderungen ist es, effiziente LEDs im gesamten Spektralbereich des UVA- und UVB-, sowie Teilen des UVC-Bereiches zu realisieren.

Bei den bisherigen Ansätzen für UV-LEDs werden für die ohmschen Kontakte auf p-dotierten Gruppe III-Nitrid-Schichten vornehmlich Ni/Au-, Pt/Ti/Au- oder Pd/Ti/Au-Metallschichten verwendet. Diese bilden zwar gute ohmsche Kontakte zu den p-dotierten Halbleiterschichten (p-Kontaktschicht) der LED, sind aber schlechte Reflektoren für Licht im UV-Bereich.

In den UV-LEDs des Standes der Technik werden p-Kontaktschichten aus p-dotiertem Galliumnitrid (p-GaN) verwendet. P-Kontaktschichten aus p-GaN weisen allerdings eine ausgeprägte Absorption von Licht im UV Spektralbereich auf, insbesondere bei Wellenlängen von 200 nm bis 400 nm.

Die UV-LEDs des Standes der Technik leiden daher an einer schlechten Lichtextraktionseffizienz im UV-Bereich. Die Menge an erfolgreich ausgekoppelten Photonen gemessen an der Menge der erzeugten Photonen beträgt lediglich 4 bis 10%.

DE10244986-A stellt einen p-Kontakt eines strahlungsemittierenden Halbleiterbauteils dar, in dem auf einer p-dotierten Schicht eine reflektierende Spiegelschicht angeordnet ist, in der metallische Kontaktelemente einbegettet sind.

JP2007324411-A stellt eine Lichtauskopplungsseite eines strahlungsemittierenden Halbleiterbauteils mit metallischen Kontakelementen dar, welches unter den metallischen Kontaktelementen noch eine zusätzliche Halbleiterkontaktschicht aufweist. Aufgabe der vorliegenden Erfindung ist es, einen oder mehrere Nachteile des Standes der Technik zu vermindern oder zu überwinden. Insbesondere ist es eine Aufgabe der vorliegenden Erfindung, UV-LEDs mit verbesserter Lichtauskopplung bereitzustellen.

Die Aufgabe wird gelöst durch Bereitstellung eines strukturierten p-Kontakts (im weiteren werden die Begriffe "p-dotierter Kontakt" und "p-Kontakt" synonym verwendet) für die Verwendung in einer Leuchtdiode für den ultravioletten Spektralbereich gemäß Anspruch 1 der beigefügten Patentansprüche. Ein wesentlicher Ansatz zur Steigerung der Lichtauskopplung von LEDs ist die Bereitstellung von im UV-Spektralbereich hochreflektierenden und gleichzeitig niederohmigen p-dotierten Kontakten. Es sind bislang keine Metalle oder Legierungen bekannt, die beide Anforderungen erfüllen können. Zwar weisen Metalle wie beispielsweise Aluminium eine geeignete Reflektivität für Licht einer Wellenlänge von 200 nm bis 400 nm auf. Für Al z.B. beträgt die Reflektivität gegen Luft bei 270 nm ca. 88%. Allerdings bilden diese Metalle keinen niederohmigen p-Kontakt im GaN-Materialsystem. Der vorliegenden Erfindung liegt die Erkenntnis zugrunde, dass es für eine effiziente Strominjektion in die p-Kontaktschicht ausreicht, wenn dazu lediglich ein Teil der dafür zur Verfügung stehenden Oberfläche der p-Kontaktschicht tatsächlich genutzt, d.h. niederohmig kontaktiert wird. Der restliche Teil der entsprechenden Oberfläche der p-Kontaktschicht kann mit einer Beschichtung versehen werden, die Licht im UV-Bereich besonders gut reflektiert. Da die p-Injektoren im Vergleich zu der UV-Licht reflektierenden Beschichtung relativ geringe Anteile der entsprechenden Oberfläche der p-Kontaktschicht bedecken, ist es möglich, insgesamt eine erhöhte UV-Reflektivität der Gesamtoberfläche zu erreichen, während eine effiziente Strominjektion in die p-Kontaktschicht gewährleistet bleibt. Sind auch die p-Injektoren von der reflektierenden Beschichtung überdeckt, so kann die UV-Reflektivität des p-Kontaktes sogar noch weiter erhöht werden. Besonders vorteilhaft ist es, wenn die reflektierende Beschichtung elektrisch leitfähig ist und ganzflächig sowohl über die dafür zur Verfügung stehenden Oberfläche der p-Kontaktschicht als auch über die p-Injektoren aufgebracht wird, da sie dann gleichzeitig als Reflektorschicht (die dann auch die Reflektivität im Bereich der p-Injektoren erhöht) und elektrische Verbindung der p-Injektoren dient. Ein besonders günstiges Verhältnis von hoher Reflektivität zu effizienter und homogener Strominjektion wird erreicht, wenn die p-Injektoren möglichst klein und möglichst homogen in einem geeigneten Abstand zueinander über die zur Verfügung stehende Oberfläche der p-Kontaktschicht verteilt und ggf. auch noch von der reflektierenden Beschichtung überdeckt sind.

Der erfindungsgemäße p-dotierte Kontakt umfasst eine p-Kontaktschicht und eine Mehrzahl von p-Injektoren. Die p-Kontaktschicht weist eine oder mehrere verschiedene p-dotierte Halbleiterschichten auf. Die Halbleiterschichten sind dabei derart ausgewählt, dass zusammen mit einer geeigneten n-dotierten Kontaktschicht eine Diode mit einer Strahlungszone entsteht, die unter angelegter elektrischer Spannung in Durchlassrichtung der Diode Licht im ultravioletten Spektralbereich emittiert, insbesondere im UV-A-, UV-B- und/oder UV-C-Bereich, bevorzugt einer Wellenlänge von 200 nm bis 400 nm. Die p-Kontaktschicht enthält oder besteht aus p-dotiertem AlGaN. Besonders bevorzugt enthält oder besteht mindestens die Halbleiterschicht der p-Kontaktschicht aus p-dotiertem AlGaN, die die zweite Oberfläche der p-Kontaktschicht bildet und auf die die p-Injektoren direkt aufgebracht sind. Dadurch wird eine verbesserte Lichtemission erreicht.

Im erfindungsgemäßen p-Kontakt weist die p-Kontaktschicht eine erste und eine zweite Oberfläche auf. Die erste Oberfläche der p-Kontaktschicht ist derart ausgeführt, dass über diese erste Oberfläche eine Strahlungszone kontaktiert wird. Unter einer Strahlungszone wird eine Zone verstanden, aus der bei Anlegung einer geeigneten Spannung Photonen emittiert werden können, bevorzugt mit einer Wellenlänge im UV-Spektralbereich, insbesondere im UV-A-, UV-B- und/oder UV-C-Bereich, bevorzugt einer Wellenlänge von 200 nm bis 400 nm. Die Strahlungszone kann beispielsweise durch eine p-n-Grenzfläche in einer Diodenanordnung mit einer geeigneten n-dotierten Schicht ausgebildet werden. Es ist auch möglich, dass die Strahlungszone durch eine so genannte aktive Zone gebildet wird, die aus einem Multiple-Quantum-Well (MQW oder Vielfachquantentopf) besteht, der wiederum zwischen einer erfindungsgemäßen p-Kontaktschicht und einer n-dotierten Schicht angeordnet ist und beispielsweise (In)AlGaN aufweisen kann oder daraus besteht. Die zweite Oberfläche weist auf der Seite, die der ersten Oberfläche abgewandt ist, eine Unterteilung in Bereiche auf, die direkt mit einer Beschichtung bedeckt sind, und in Bereiche, die direkt mit einer Mehrzahl von p-Injektoren besetzt sind. Dabei weist die Beschichtung ein Material auf, welches für Licht mit einer Wellenlänge von 200 nm bis 400 nm, bevorzugt für Licht mit einer Wellenlänge von 270 nm, eine maximale Reflektivität von mindestens 60%, bevorzugt von mindestens 80%, aufweist.

Die Summe der Bereiche, die direkt mit einer Beschichtung bedeckt sind, beträgt erfindungsgemäß 75% bis 96%. Der Teil der zweiten Oberfläche der p-Kontaktschicht, der nicht von der Beschichtung bedeckt ist, kann für die Anordnung von einer Mehrzahl von p-Injektoren genutzt werden. Die p-Injektoren sind dabei direkt auf der zweiten Oberfläche der p-Kontaktschicht angebracht und es befindet sich keine erfindungsgemäße Beschichtung zwischen p-Injektoren und der zweiten Oberfläche der p-Kontaktschicht. Die p-Injektoren auf der p-Kontaktschicht können allerdings von der erfindungsgemäßen Beschichtung überdeckt sein und/oder mit dieser in Kontakt stehen. Dies kann insbesondere dann der Fall sein, wenn die erfindungsgemäße Beschichtung über die gesamte Oberfläche der zweiten Oberfläche der p-Kontaktschicht mit darauf bereits platzierten p-Injektoren aufgebracht oder abgeschieden wird.

Die p-Injektoren dienen dazu, einen niederohmigen Kontakt zwischen den p-Injektoren und der p-Kontaktschicht herzustellen und somit eine effiziente Strominjektion von einer Stromquelle über die p-Injektoren in die p-Kontaktschicht zu gewährleisten. Typische spezifische Kontaktwiderstände liegen hierbei im Bereich 10⁻² bis 10⁻⁴ Ωcm² oder darunter. Wesentlich ist, dass die p-Injektoren direkt auf der zweiten Oberfläche der p-Kontaktschicht angebracht sind und zwischen p-Injektor und p-Kontaktschicht keine erfindungsgemäße Beschichtung vorgesehen ist. Dabei kann die Summe der Flächen, die von p-Injektoren besetzt sind, addiert mit der Summe der Flächen, die mit der Beschichtung bedeckt sind, der Gesamtfläche der zweiten Oberfläche der p-Kontaktschicht entsprechen oder kleiner sein. Bevorzugt ist die gesamte Fläche der zweiten Oberfläche der p-Kontaktschicht, die nicht von p-Injektoren besetzt ist, mit der Beschichtung bedeckt.

Die Beschichtung weist ein Material auf, welches für Licht mit einer Wellenlänge von 200 nm bis 400 nm, bevorzugt für Licht mit einer Wellenlänge von 270 nm, eine maximale Reflektivität von mindestens 60% aufweist, bevorzugt von mindestens 80%, besonders bevorzugt von mindestens 85%. Unter maximaler Reflektivität wird eine Reflektivität verstanden, die, auch bei einer weiteren Zunahme an Schichtdicke des zu betrachtenden Materials, nicht mehr weiter zunimmt. Dem Fachmann sind geeignete Materialien sowie geeignete Verfahren zur Testung der Reflektivität bekannt, so dass der Fachmann ohne unzumutbaren Aufwand für ein bestimmtes Material zuverlässig bestimmen kann, ob dieses die notwendige maximale Reflektivität für Licht einer Wellenlänge von 200 nm bis 400 nm, bevorzugt für Licht mit einer Wellenlänge von 270 nm, aufweist. Ein Beispiel für ein solches Material ist Aluminium (Al), welches eine maximale Reflektivität bei 270 nm von ca. 88% aufweist. Bevorzugt ist das Material oder Materialgemisch der Beschichtung elektrisch leitfähig, so dass die erfindungsgemäße Beschichtung, wenn sie beispielsweise sowohl über die dafür zur Verfügung stehenden Oberfläche der p-Kontaktschicht als auch über die p-Injektoren aufgebracht wird, gleichzeitig als Reflektorschicht und elektrische Verbindung der p-Injektoren untereinander dient.

Die p-Injektoren weisen mindestens eine p-Injektormetallschicht auf, die eine effiziente ohmsche Verbindung der p-Kontaktschicht mit einem Pol einer Strom- oder Spannungsquelle erlaubt. Da die p-Injektoren selbst nicht UV-reflektierend sein müssen, ist die Auswahl geeigneter Materialien nicht auf solche beschränkt, die auch eine gute Reflektivität im UV-Bereich aufweisen. So können auch Materialien und Metalle zum Einsatz kommen, die bereits im Stand der Technik bei der Herstellung von p-Injektoren verwendet worden sind. Die p-Injektoren weisen erfindungsgemäß eine p-Injektormetallschicht auf, die Au, Ni, Pd, Pt, Rh, Ti, Ni/Au, Pd/Ti/Au, Pd/Pt/Au oder Pt/Ti/Au enthält oder daraus besteht. Neben einer solchen p-Injektormetallschicht können die p-Injektoren noch weitere metallische und/oder nicht-metallische Schichten aufweisen, vorausgesetzt diese zusätzlichen Schichten führen nicht dazu, dass eine ohmsche Verbindung der p-Kontaktschicht mit einem Pol einer Strom- oder Spannungsquelle über die p-Injektoren unterbunden oder wesentlich funktional beeinträchtigt wird. Die p-Injektoren weisen erfindungsgemäß zusätzlich eine p-Injektorschicht auf, die einen p-dotierten Halbleiter, beispielsweise p-GaN oder p-InGaN enthält oder daraus besteht. Dies ist insbesondere dann bevorzugt, wenn die Halbleiterschicht, die die zweite Oberfläche (B) der p-Kontaktschicht (2) bildet und auf die die p-Injektoren direkt aufgebracht sind, p-dotiertes AlGaN aufweist oder daraus besteht. Somit wird ein p-Kontakt erhalten, der sich durch besonders günstiges Verhältnis von Lichtemission zu elektrischen Eigenschaften auszeichnet.

Der erfindungsgemäße p-dotierte Kontakt zeichnet sich durch besonders günstige Eigenschaften aus, wenn die p-Injektoren in einer besonderen Form, Dimension und/oder Struktur auf der zweiten Oberfläche der p-Kontaktschicht angeordnet sind. Dabei können die p-Injektoren als nanopixel-artig über die gesamte zweite Oberfläche der p-Kontaktschicht verteilte ohmsche Kontakte vorliegen. Bevorzugt sind die p-Injektoren in einem regelmäßigen Muster auf der zweiten Oberfläche der p-Kontaktschicht angeordnet.

Die p-Injektoren können eine viereckige, eine rechteckige, eine quadratische, eine runde, eine elliptische, eine dreieckige und/oder eine polygonale Form aufweisen. Die p-Injektoren können auch linienförmig, z. B. als parallele Linien oder als sich kreuzende Linien angeordnet sein. Dabei können die p-Injektoren eines erfindungsgemäßen p-Kontakts gleiche oder unterschiedliche Formen aufweisen.

Bevorzugt weisen die p-Injektoren einzeln jeweils eine maximale Breite D von 10 nm bis 50 µm auf, bevorzugt von 10 nm bis 2 µm, besonders bevorzugt von 50 nm bis 1 µm. Unter einer maximalen Breite wird eine maximale Ausdehnung der p-Injektoren in einer ersten Dimension x verstanden, die nicht größer ist als eine maximale Ausdehnung der p-Injektoren in einer zweiten Dimension y (einer maximalen Länge), wobei die erste und zweite Dimension (x, y) in einem rechten Winkel zueinander stehen. Bei einer rechteckigen Form entspricht die maximale Breite der kurzen Seite des Rechtecks, während die maximale Länge der langen Seite entspricht; bei einem Kreis entspricht die maximale Breite dem Durchmesser; bei einem Quadrat entspricht die maximale Breite einer beliebeigen Seite; usw..

Die Mehrzahl an p-Injektoren kann zufällig auf der zweiten Oberfläche der p-Kontaktschicht verteilt sein, bevorzugt aber in einer vorher festgelegten Art und Weise. Dazu können die p-Injektoren zu ihren jeweils benachbarten p-Injektoren einen Abstand A von 20 nm bis 20 µm aufweisen, bevorzugt von 20 nm bis 5 µm, besonders bevorzugt von 100 nm bis 2 µm. Die p-Injektoren eines erfindungsgemäßen p-Kontakts können auf der zweiten Oberfläche der p-Kontaktschicht gleichmäßig verteilt angeordnet sein. Dazu können die Abstände A der p-Injektoren zu ihren jeweils benachbarten p-Injektoren für alle p-Injektoren gleich gewählt sein.

Insbesondere können *D* und *A* so gewählt sein, dass das Verhältnis *D* zu *A* 1:1 bis 1:4 beträgt. In einer besonderen Ausführungsform ist D 0,5 µm und A ist ausgewählt aus 0,5 µm bis 2 µm. Alternativ kann *D* ausgewählt sein aus dem Bereich von 50 nm bis 100 nm und *A* aus dem Bereich von 100 nm bis 200 nm.

Der erfindungsgemäße p-Kontakt lässt sich dadurch herstellen, dass zunächst die p-Kontaktschicht durch bekannte Verfahren, z.B. durch Epitaxie-Verfahren, wie z.B. metallorganische Gasphasenepitaxie, Molekularstrahlepitaxie oder Hydride Vapor Phase Epitaxy, in an sich bekannter Weise bereitgestellt wird. P-Injektoren können mit verschiedenen Verfahren abgeschieden werden, wie z.B. Elektronenstrahlverdampfen, thermischem Verdampfen oder Sputter-Techniken. Die Strukturierung der Kontakte erfolgt über lithographische Verfahren, wie z.B. Photolithographie, Nanoimprinting, Elektronenstrahl-Verfahren.

Die vorliegende Erfindung bezieht sich auch auf eine Leuchtdiode umfassend einen erfindungsgemäßen p-dotierten Kontakt. Insbesondere bezieht sich die Erfindung auf eine Leuchtdiode, umfassend eine Strahlungszone, die zwischen einem n-dotierten Kontakt und einem erfindungsgemäßen p-dotierten Kontakt angeordnet ist, und bevorzugt Licht im UV-Bereich, besonders bevorzugt im UV-A-, UV-B- und/oder UV-C-Bereich, ganz besonders bevorzugt Licht mit einer Wellenlänge von 200 nm bis 400nm emittiert. In einer weiteren bevorzugten Ausführungsform emittiert die Leuchtdiode Licht mit einer Wellenlänge von 200 nm bis 380 nm oder von 200 nm bis 350 nm.
- FIG. 1: zeigt eine schematische Darstellung eines Aufbaus eines erfindungsgemäßen p-dotierten Kontakts, wobei die p-Injektoren eine Ni/Au-Schicht und eine p-(In)GaN-Schicht aufweisen, die Beschichtung aus Al besteht und die p-Kontaktschicht eine p-AlGaN-Schicht aufweist.
- FIG. 2: zeigt eine schematische Darstellung eines Aufbaus eines erfindungsgemäßen p-dotierten Kontakts wie in FIG. 1, wobei reflektierende Beschichtung zusätzlich auch die p-Injektoren überdeckt.
- FIG. 3: zeigt eine schematische Darstellung der Struktur einer zweiten Oberfläche B einer p-Kontaktschicht des erfindungsgemäßen p-dotierten Kontakts aus FIG. 1, wobei die p-Injektoren gleichmäßig verteilt vorliegen und eine quadratische Form mit einer Kantenlänge von 0,5µm und einen Abstand zueinander von 1µm aufweisen.
- FIG. 4: in FIG. 4A ist schematisch dargestellt, welche Strecke durch die Angabe "distance from contact" (Abstand zum p-Injektor) beschrieben wird; in FIG. 4B sind die berechneten Stromdichten in Abhängigkeit vom jeweiligen Abstand zum p-Injektor aufgetragen, wobei die Kurven für drei p-Kontakte mit unterschiedlicher Ls ("current spreading length" = Entfernung vom p-Injektor bei der die Stromdichte auf 1/e abgefallen ist) dargestellt sind.
- FIG. 5: zeigt eine schematische Darstellung der Schichtstruktur einer UV Leuchtdiode enthaltend einen erfindungsgemäßen p-Kontakt.

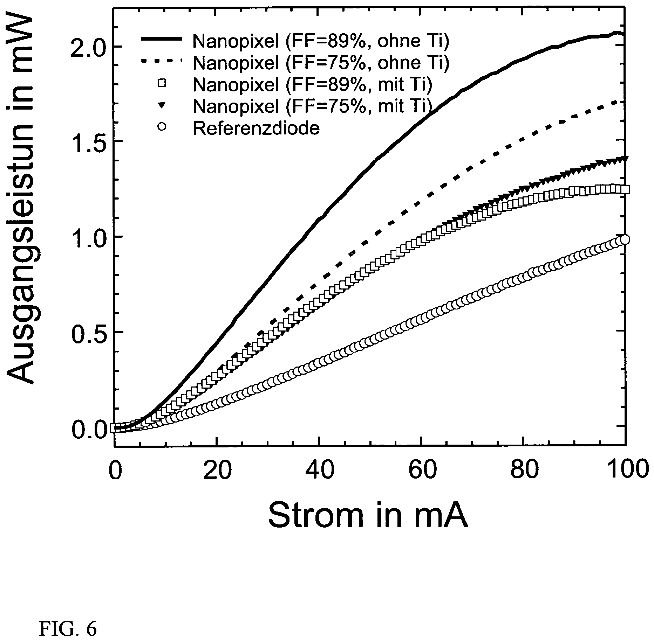

- FIG. 6: zeigt Lichtausgangsleistung-Strom-Kennlinien für verschiedene Nanopixel-LEDs im Vergleich zu einer Referenzdiode mit unstrukturiertem Pd-Kontakt. Zwei Nanopixel-LED Geometrien wurden verglichen: Eine LED mit einer Kontaktseitenlänge von D = 1µm und einem Abstand von A = 1 µm (Füllfaktor FF= 75%) und eine weitere Nanopixel-LED mit einer Kontaktseitenlänge von D = 1µm und einem Abstand von A = 2 µm (Füllfaktor FF= 89%). Eine Hälfte der Wafer mit Nanopixel LEDs wurde mit einer Ti/Al/Pt/Au (5/50/40/400 nm) Reflexionsschicht, die andere mit einem UV-Reflektierenden Metallschichtsystem ohne die Ti-Haftschicht (nur Al/Pt/Au mit Schichtdicken von 50/40/400 nm) hergestellt. Die Emissionswellenlänge lag bei allen LEDs bei 380 nm.
Im folgenden wird die Erfindung anhand von ausgewählten Ausführungsbeispielen näher erläutert.

### Beispiel 1: Aufbau eines erfindungsgemäßen p-dotierten Kontakts

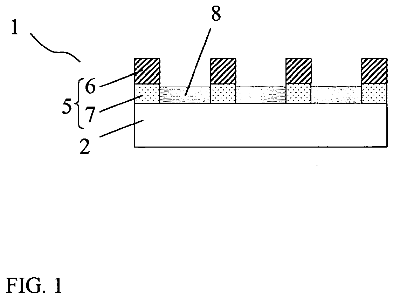

In FIG. 1 ist eine beispielhafte Ausführungsform eines erfindungsgemäßen p-dotierten Kontakts schematisch dargestellt. Der erfindungsgemäße p-dotierte Kontakt 1 weist eine p-Kontaktschicht 2 und eine Mehrzahl von p-Injektoren 5 auf. Dabei weist die p-Kontaktschicht 2 eine erste Oberfläche A auf, die derart ausgestaltet ist, dass sie in einer LED-Anordnung mit einer geeigneten Strahlungszone kontaktierbar ist. Die p-Kontaktschicht 2 weist eine zweite Oberfläche B auf, wobei auf der der ersten Oberfläche A abgewandten Seite der Oberfläche B eine Beschichtung 8 und eine Mehrzahl von p-Injektoren 5 angebracht sind. Die p-Kontaktschicht 2 wird von einer p-AlGaN-Schicht gebildet und ist somit besonders UV transparent.

Auf der Oberfläche B der p-Kontaktschicht 2 sind eine Mehrzahl von p-Injektoren 5 angeordnet, wobei die p-Injektoren 5 direkt mit der Oberfläche B verbunden sind. Die p-Injektoren 5 sind derart ausgeführt, dass ein niederohmiger Kontakt zwischen den p-Injektoren 5 und der p-Kontaktschicht 2 entsteht, der es erlaubt die p-Kontaktschicht 2 leitend (mit geringen ohmschen Verlusten) mit einem Pol einer Strom- oder Spannungsquelle zu verbinden. Die p-Injektoren 5 weisen zwei Schichten auf, eine der Oberfläche B abgewandte p-Injektormetallschicht 6, beispielsweise eine Ni/Au-Metallschicht, und eine zwischen p-Injektormetallschicht 6 und p-Kontaktschicht 2 angeordnete zusätzliche p-Injektorschicht 7, beispielsweise eine p-(In)GaN-Halbleiterschicht. Die p-Injektormetallschicht 6 dient dazu, einen niederohmigen Kontakt mit einem Pol einer Strom- und/oder Spannungsquelle herzustellen. Die p-Injektorschicht 7 dient der möglichst effektiven Strominjektion in die p-Kontaktschicht 2. Die p-Injektoren 5 sind in gleichmäßigen Abständen auf der Oberfläche B der p-Kontaktschicht 2 verteilt angebracht.

Die Teile der Oberfläche B, die nicht von p-Injektoren 5 besetzt sind, weisen eine Beschichtung 8 mit einem Material auf, welches Licht mit einer Wellenlänge von 270 nm zu mindestens 60%, vorzugsweise zu mindestens 80% reflektiert. Im Beispiel in FIG. 1 besteht die Beschichtung 8 aus einer Aluminiumschicht (Al) mit einer Schichtdicke von 50 bis 350nm.

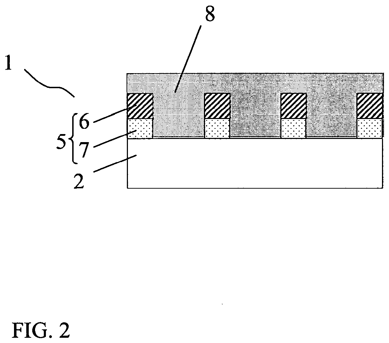

In FIG. 2 ist eine weitere Ausführungsform des erfindungsgemäßen p-dotierten Kontakts gezeigt. Diese weitere Ausführungsform unterscheidet sich von der Ausführungsform aus FIG. 1 lediglich dadurch, dass die Al-Beschichtung zusätzlich auch die p-Injektoren 5 bedeckt. Da die Beschichtung 8 aus Al besteht, ist diese elektrisch leitend und verbindet die p-Injektoren 5 elektrisch miteinander.

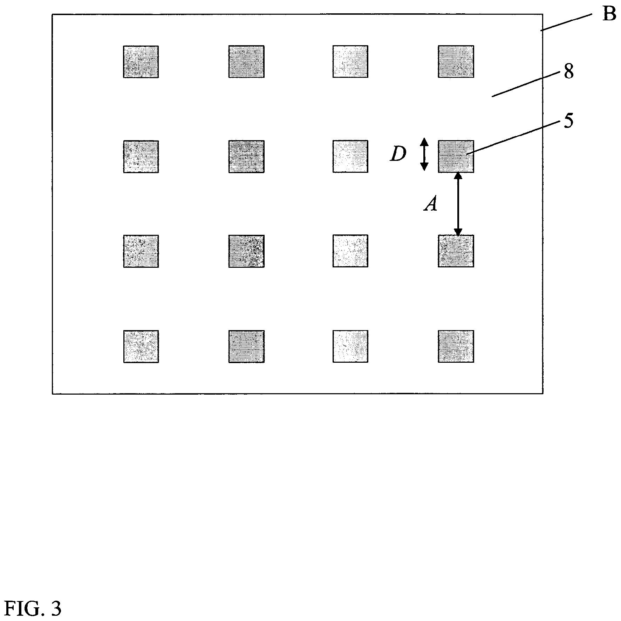

In FIG. 3 ist eine schematische Darstellung der Struktur einer zweiten Oberfläche B einer p-Kontaktschicht des erfindungsgemäßen p-dotierten Kontakts aus FIG. 1 als Draufsicht gezeigt, einschließlich der Beschichtung 8 und der p-Injektoren 5. Die p-Injektoren 5 weisen eine quadratische Form auf mit einer maximalen Breite *D* von 0,5 µm. Die p-Injektoren 5 sind dabei auf der Oberfläche B der p-Kontaktschicht 2 gleichmäßig verteilt angebracht und weisen jeweils einen einheitlichen Abstand A von 1 µm zu den jeweils benachbarten p-Injektoren 5 auf. Die Teile der Oberfläche B, die nicht von p-Injektoren 5 besetzt sind, weisen eine Beschichtung 8 auf, die aus Aluminium besteht mit einer Reflektivität bei 270 nm von 88%. Die Beschichtung 8 bedeckt ∼90% der Oberfläche B der p-Kontaktschicht 2. Damit weist die gesamte Oberfläche B einschließlich der Beschichtung 8 und der p-Injektoren 5 eine maximale Reflektivität von ca. 79% auf. Diese Reflektivität ist höher als jede Reflektivität, die mit herkömmlichen niederohmigen p-Kontakten erreichbar ist.

### Beispiel 2: Modellrechnung zur Abnahme der Stromdichte in Abhängigkeit vom Abstand zum p-Injektor

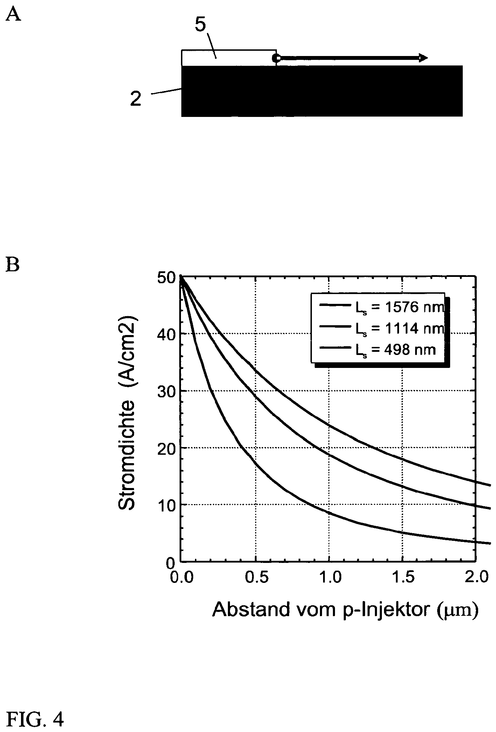

Damit der erfindungsgemäße p-dotierte Kontakt auch in einer LED verwendet werden kann, ist es notwendig, dass eine ausreichende Strominjektion in die p-Kontaktschicht des p-dotierten Kontakts erfolgt. In FIG. 4B ist die berechnete Abnahme der Stromdichte in einer p-Kontaktschicht einer LED bei zunehmendem Abstand zum ohmschen p-Injektor gezeigt. Die Berechnungen basieren auf einem einfachen analytischen Modell nach G.H.B. Thompson (Physics of Semiconductor Laser Devices, John Wiley & Sons (1980)) und Hyunsoo Kim et al. (Measurements of current spreading length and design of GaN-based light emitting diodes, Appl. Phys. Lett. 90, 063510 (2007)). Bei der Simulation wird angenommen, dass kein Strom über die (vergleichsweise hochohmigen) Aluminium-Reflektoren injiziert wird. Die übrigen Parameter der Modellsimulation sind in Tabelle 1 aufgeführt.

**Tabelle 1. Parameter der Modellsimulation**

| | A | B | C |
|---|---|---|---|
| p-Kontaktschichtdicke dₚ [nm] | 300 | 300 | 600 |
| Ladungsträgerdichte in p-Kontaktschicht p [cm⁻³] | 1E+17 | 5E+17 | 5E+17 |
| Ladungsbeweglichkeiten in p-Kontaktschicht [cm²/Vs] | 10 | 10 | 10 |
| "current spreading length" Lₛ [nm] | 498 | 1114 | 1576 |

In FIG. 4B ist die berechnete Stromdichte in der p-AlGaN-Schicht (der p-Kontaktschicht des Modells und des Beispiels 1) in Abhängigkeit vom Abstand zum p-Injektor gezeigt. In FIG. 4A ist schematisch verdeutlicht, welche Strecke damit gemeint ist. FIG. 4B zeigt die Ergebnisse für drei verschiedene p-Kontakte mit jeweils unterschiedlicher Ls. Die Größe Lₛ bezeichnet hierbei die sogenannte "current spreading length" (die Stromausbreitungsstrecke) und damit die Entfernung vom p-Injektor bei der die Stromdichte auf 1/e abgefallen ist. Die "Current Spreading Length" ist wiederum abhängig von der Dicke, der Ladungsträgerdichte und den Beweglichkeiten in den p-dotierten Schichten (siehe Tabelle 1).

Für einen p-Injektor mit einer maximalen Breite D von 0,5 µm und einen Abstand A zwischen den p-Kontakten von 1µm, einer p-Kontaktschicht aus p-AlGaN entsprechend Modell C (also wie in Beispiel 1), fällt die Stromdichte zwar leicht von 50 A/cm² auf 25 A/cm² ab, ist allerdings immer noch ausreichend, um einen effektiven Betrieb des p-dotierten Kontakts in einer LED zu gewährleisten. Dabei ist in der Rechnung noch nicht berücksichtigt worden, dass die Inhomogenitäten in der realen Nanopixelstruktur deutlich geringer sein werden, da durch die Ladungsträgerinjektion vom nächstgelegenen Nachbarinjektor für einen bestimmten Punkt der P-Kontaktschicht insgesamt die Summe der jeweils berechneten Stromdichten der umliegenden p-Injektoren erreicht werden.

### Beispiel 3: UV Leuchtdiode enthaltend einen erfindungsgemäßen p-Kontakt

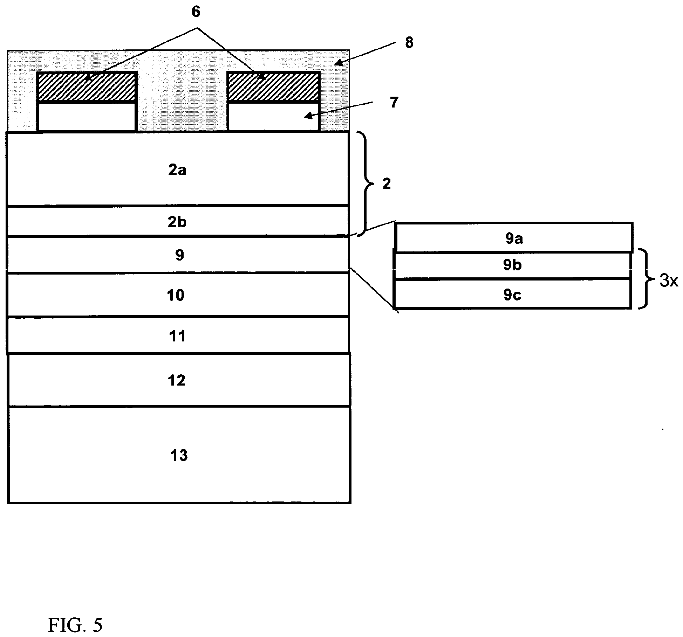

In FIG. 5 ist beispielhaft eine Ausführungsform einer erfindungsgemäßen Leuchtdiode enthaltend einen erfindungsgemäßen p-Kontakt als schematische Ausschnittsdarstellung gezeigt.

Erfindungsgemäß umfasst die UV-Leuchtdiode einen p-Kontakt umfassend p-Injektoren, die jeweils aus einer p-Injektormetallschicht 6 und einer p-(In)GaN-Injektorschicht 7 gebildet sind. Im gezeigten Beispiel weisen die p-(In)GaN-Injektorschichten 7 jeweils eine Dimension auf von 10 nm p-(In)GaN mit einer Magnesium (Mg) Dotierkonzentration von [Mg]=1E20cm⁻³. Die p-(In)GaN-Injektorschichten 7 stehen in direktem Kontakt mit einer p-Kontaktschicht 2 aus p-dotiertem AlGaN. Im gezeigten Beispiel ist die p-Kontaktschicht aus einer abwechselnden Folge 2a von zwei p-dotierten AlGaN-Schichten gebildet mit folgenden Zusammensetzungen: p-Al_{0,45}Ga_{0,55}N und p-Al_{0,55}Ga_{0,45}N; wobei die einzelnen Schichten eine Dicke von 2 nm aufweisen und die p-Kontaktschicht insgesamt 50 Schichten der einen und 50 Schichten der anderen Zusammensetzung aufweist und deren Schichten eine Mg-Dotierkonzentration von [Mg]=5E19cm⁻³ aufweisen. Auf der der p-Injektoren abgewandten Seite weist die p-Kontaktschicht eine abschließende 20 nm dicke Schicht 2b mit der Zusammensetzung p-Al_{0,60}Ga_{0,40}N (mit [Mg]=1E20cm⁻³) auf. Die mit den p-Injektoren in Kontakt stehende Oberfläche der p-Kontaktschicht 2 ist mit einer erfindungsgemäßen Beschichtung bedeckt. Im gezeigten Beispiel ist die Beschichtung 8 derart ausgestaltet, dass die Beschichtung 8 nicht nur eine Oberfläche der p-Kontaktschicht 2 bedeckt, sondern auch die p-Injektoren bedeckt. Auf der der p-Injektoren abgewandten Seite der p-Kontaktschicht 2 schließt sich im gezeigten Beispiel eine Vielfachquantentopfstruktur 9 an. Diese Vielfachquantentopfstruktur 9 kann aus einer regelmäßigen Abfolge von Schichtungen von n Quantentopfschichten und n+1 Barriereschichten gebildet sein. Im gezeigten Beispiel wird die Vielfachquantentopfstruktur 9 aus einer 6 nm dicken (In)Al_{0,5}Ga_{0,5}N-Barriereschicht 9a und einer dreimaligen Wiederholung der Schichtabfolge einer 2 nm dicken (In)Al_{0,4}Ga_{0,6}N-Quantentopfschicht 9b und einer 6 nm dicken (In)Al_{0,5}Ga_{0,5}N-Barriereschicht 9c gebildet. Auf der der p-Kontaktschicht abgewandten Seite der Vielfachquantentopfstruktur 9 folgt eine 1500 nm dicke Schicht 10 aus n-Al_{0,5}Ga_{0,5}N mit einer Silizium (Si) Dotierkonzentration von [Si]=5E18cm⁻³. Die n-dotierte Schicht 10 wird gefolgt von einer 200 nm starken Schicht 11 aus undotiertem Al_{0,5}Ga_{0,5}N. Daran schließt sich eine 1000 nm dicke Schicht 12 aus undotiertem AIN an. Die Schicht 12 wird auf der dem p-Kontakt abgewandten Seite von einer Saphirschicht 13 bedeckt.

### Beispiel 4: Vergleich erfindungsgemäße UV-LED vs. Stand der Technik

Die UV-LED Struktur wurde durch dem physikalischen Beschichtungsverfahren Metallorganische Gasphasenepitaxie (engl. "metal-organic vapour phase epitaxy" oder abgekürzt MOVPE) auf einem (0001)-orientierten Saphir-Substrat mit einem Durchmesser von zwei Zoll (50 mm) aufgewachsen. Die Schicht-Struktur besteht aus einer mit Silizium dotierten 3.4 µm dicken GaN Buffer-Schicht, einer 10 nm Si dotierten Al_{0.23}Ga_{0.77}N Löcher-Barriere, einer aktiven Zone bestehend aus fünf 3 nm dicken In_{0.04}GaN Quantenfilmen getrennt von 6 nm dicken in_{0.04}Al_{0.16}GaN Barrieren (engl. "multiple-quantum wells" oder abgekürzt MQW), gefolgt von einer 10 nm mit Magnesium dotierten Al_{0.23}Ga_{0.77}N Elektronenbarrierenschicht und abschließend einer 200 nm dicken Mg-dotierten GaN Schicht. Nach der MOVPE wurden die p-Dotierung in einen Rapid Thermal Annealing (RTA) Ofen bei 815 Grad Celsius für 10 Minuten in einer Stickstoffatmosphäre aktiviert.

Die Bauelemente wurden anschließend prozessierungstechnologisch strukturiert. Auf der zweiten Oberfläche der p-Kontaktschicht mit einer Fläche von 0.0225 mm² wurde eine Anzahl von quadratischen Pd-Kontakten strukturiert. Das Palladium hat eine Schichtdicke von 30 nm und wurde mittels Elektronenstrahlverdampfung abgeschieden. Der Pd-Abdeckungsfaktor beträgt 25% für eine Kontaktseitelänge von D=1 µm und eine Abstand von A=1 µm und 11 % für D=1 µm, A=2 µm. Die p-Elektrode, die eine UV-reflektierende Aluminiumschicht beinhalt, besteht aus dem Metallsystem Al(50nm)/Pt(40nm)/Au(400nm). Das UV-reflektierende Metallsystem überdeckt sowohl die p-Injektoren als auch die freien GaN Bereiche. D. h. der Anteil der Fläche, der mit der UV-reflektierenden Schicht bedeckt ist (entspricht dem Füllfaktor, kurz FF), beträgt jeweils 75% und 89%. Bei der Hälfte der Proben wurde zwischen der GaN Oberfläche und dem Aluminium-Reflektor eine dünne Ti-Schicht als Haftvermittler eingefügt um die Haftung zwischen Al und GaN zu verbessern, d.h. in diesen Fall entspricht die Schichtfolge dem Metallsystem Ti(5nm)/Al(50nm)/Pt(40nm)/Au(400nm). Da Ti kein guter UV-Reflektor ist, wurde eine nur 5 nm dicke Ti-Schicht aufgedampft um die Absorption zu minimieren. Nach Abschluss der p-seitigen Metallisierung wurde mittels eines Inductively Coupled Plasma Trockenätzverfahren in einer Cl₂ und BCl₃ Atmosphäre 150 µm x 150 µm große Mesa-Strukturen herausgeätzt, die bis zur n-dotierten GaN Buffer Schicht reichen. Danach wurde die n-Metallisierung Ti(10nm)/Al(50nm)/Mo(20nm)/Au(200nm) aufgedampft. Die gesamte Chip-Größe beträgt 500 µm x 500 µm.

FIG. 6 zeigt die gemessenen Lichtausgangsleistung-Strom-Kennlinien für verschiedene Nanopixel-LEDs im Vergleich zu einer Referenzdiode mit unstrukturiertem Pd-Kontakt und ohneAl-Beschichtung. Die besten Ergebnisse wurden mit der Nanopixel LED mit FF=89% ohne Ti-Haftschicht erzielt. Bei 50 mA Vorwärtsstrom zeigt diese eine Lichtausgangsleistung von 1.36 mW (gemessen on-Wafer), was mehr als dreimal so hoch ist wie die Lichtleistung der Referenzdiode (0.45mW bei 50 mA).

### Bezugszeichenliste

- 1: p- Kontakt
- 2: p-Kontaktschicht aus p-dotiertem AlGaN
2a abwechselnden Folge von zwei p-AlGaN-Schichten mit den Zusammensetzungen: p-Al_{0,45}Ga_{0,55}N und p-Al_{0,55}Ga_{0,45}N
2b Schicht mit der Zusammensetzung p-Al₀,₆₀Ga_{0,40}N
- 5: p-Injektor
- 6: p-Injektormetallschicht aus Ni/Au
- 7: p-Injektorschicht aus (In)GaN
- 8: Beschichtung mit einem Material, welches Licht mit einer Wellenlänge von 270 nm zu mindestens 60% vorzugsweise zu mindestens 80% reflektiert
- 9: Vielfachquantentopfschicht
9a (In)Al_{0,5}Ga_{0,5}N-Barriereschicht
9b (In)Al_{0,4}Ga_{0,6}N-Quantentopfschicht
9c (In)Al_{0,5}Ga_{0,5}N-Barriereschicht
- 10: n-dotierte Schicht aus n-Al_{0,5}Ga_{0,5}N
- 11: undotierte Schicht aus Al_{0,5}Ga_{0,5}N
- 12: undotierte Schicht aus AIN
- 13: Saphirschicht

- A: erste Oberfläche der p-Kontaktschicht 2
- B: zweite Oberfläche der p-Kontaktschicht 2

## Patentansprüche

1. P-dotierter Kontakt (1) für die Verwendung in einer Leuchtdiode für den ultravioletten Spektralbereich, umfassend eine p-Kontaktschicht (2) enthaltend oder bestehend aus p-AlGaN mit einer ersten Oberfläche (A) zur Kontaktierung einer Strahlungszone und einer zweiten Oberfläche (B), die auf der der ersten Oberfläche (A) abgewandten Seite:
a) eine Beschichtung (8) aufweist, die 75%-96% der zweiten Oberfläche (B) der p-Kontaktschicht (2) direkt kontaktiert und die ein Material enthält oder daraus besteht, welches für Licht im UV Bereich mit einer Wellenlänge von 200 nm bis 400 nm eine maximale Reflektivität von mindestens 60 % aufweist; und
b) eine Mehrzahl von p-Injektoren (5) aufweist, die direkt auf der zweiten Oberfläche (B) der p-Kontaktschicht (2) angeordnet sind ;
wobei die p-Injektoren (5) neben einer p-Injektormetallschicht (6), die eine ohmsche Verbindung der p-Kontaktschicht (2) mit einer Stromquelle erlaubt und Au, Ni, Pd, Pt, Rh, Ti, Ni/Au, Pd/Ti/Au, Pd/Pt/Au oder Pt/Ti/Au enthält oder daraus besteht, noch eine weitere p-Injektorschicht (7) aufweisen, die p-GaN oder p-(In)GaN enthält oder daraus besteht.

2. P-dotierter Kontakt (1) gemäß einem der vorhergehenden Ansprüche, **dadurch gekennzeichnet, dass** die Beschichtung (8) elektrisch leitfähig ist.

3. P-dotierter Kontakt (1) gemäß einem der vorhergehenden Ansprüche, **dadurch gekennzeichnet, dass** die Beschichtung (8) Al enthält oder daraus besteht.

4. P-dotierter Kontakt (1) gemäß einem der vorhergehenden Ansprüche, **dadurch gekennzeichnet, dass** die p-Kontaktschicht (2) eine oder mehrere verschiedene Halbleiterschichten aufweist.

5. P-dotierter Kontakt (1) gemäß einem der vorhergehenden Ansprüche, **dadurch gekennzeichnet, dass** die Halbleiterschicht, die die zweite Oberfläche (B) der p-Kontaktschicht (2) bildet und auf die die p-Injektoren direkt aufgebracht sind, p-dotiertes AlGaN aufweist oder daraus besteht.

6. P-dotierter Kontakt (1) gemäß einem der vorhergehenden Ansprüche, **dadurch gekennzeichnet, dass** die p-Injektoren (5) eine maximale Breite *D* von 10 nm bis 50 µm aufweisen.

7. P-dotierter Kontakt (1) gemäß einem der vorhergehenden Ansprüche, **dadurch gekennzeichnet, dass** die p-Injektoren (5) zu ihren jeweils benachbarten p-Injektoren (5) einen Abstand *A* von 20 nm bis 20 µm aufweisen.

8. P-dotierter Kontakt (1) gemäß einem der vorhergehenden Ansprüche, **dadurch gekennzeichnet, dass** die Abstände *A* der p-Injektoren (5) zu ihren benachbarten p-Injektoren (5) für alle p-Injektoren (5) gleich ist.

9. P-dotierter Kontakt (1) gemäß einem der vorhergehenden Ansprüche, **dadurch gekennzeichnet, dass** *D* und *A* so gewählt sind, dass das Verhältnis *D* zu *A* 1:1 bis 1:4 beträgt.

10. P-dotierter Kontakt (1) gemäß einem der vorhergehenden Ansprüche, **dadurch gekennzeichnet, dass** die p-Injektoren (5) in einem regelmäßigen Muster auf der zweiten Oberfläche (B) der p-Kontaktschicht (2) angeordnet sind.

11. Leuchtdiode umfassend eine Strahlungszone, die zwischen einem n-dotierten Kontakt und einem p-dotierten Kontakt (1) gemäß einem der Ansprüche 1 bis 10 angeordnet ist.

12. Leuchtdiode nach Anspruch 11, wobei die Leuchtdiode Licht im UV-Bereich von 200 nm bis 400 nm emittiert, bevorzugt im UV-A, UV-B- und/oder im UV-C-Bereich.

## Claims

1. P-doped contact (1) for use in a light-emitting diode for the ultraviolet spectral range, comprising a p-contact layer (2) containing or consisting of p-AlGaN having a first surface (A) for contacting a radiation zone and a second surface (B) comprising, on the side facing away from the first surface (A):
a) a coating (8) which directly contacts 75%-96% of the second surface (B) of the p-contact layer (2) and which contains or consists of a material having a maximum reflectivity of at least 60% for light in the UV range with a wavelength of 200 nm to 400 nm; and
b) a plurality of p-injectors (5) which are disposed directly on the second surface (B) of the p-contact layer (2),
wherein the p-injectors (5) comprise, in addition to a p-injector metal layer (6) which enables an ohmic connection of the p-contact layer (2) to a current source and contains or consists of Au, Ni, Pd, Pt, Rh, Ti, Ni/Au, Pd/Ti/Au, Pd/Pt/Au or Pt/Ti/Au, a further p-injector layer (7) which contains or consists of p-GaN or p-(In)GaN.

2. P-doped contact (1) according to any of the preceding claims, **characterized in that** the coating (8) is electrically conductive.

3. P-doped contact (1) according to any of the preceding claims, **characterized in that** the coating (8) contains or consists of Al.

4. P-doped contact (1) according to any of the preceding claims, **characterized in that** the p-contact layer (2) comprises one or more different semiconductor layers.

5. P-doped contact (1) according to any of the preceding claims, **characterized in that** the semiconductor layer, which forms the second surface (B) of the p-contact layer (3) and onto which the p-injectors are directly applied, comprises or consists of p-doped AlGaN.

6. P-doped contact (1) according to any of the preceding claims, **characterized in that** the p-injectors (5) have a maximum width *D* of 10 nm to 50 µm.

7. P-doped contact (1) according to any of the preceding claims, **characterized in that** the p-injectors (5) have a distance *A* of 20 nm to 20 µm from their respectively adjacent p-injectors (5).

8. P-doped contact (1) according to any of the preceding claims, **characterized in that** the distances *A* of the p-injectors (5) from their adjacent p-injectors (5) are identical for all p-injectors (5).

9. P-doped contact (1) according to any of the preceding claims, **characterized in that** *D* and *A* are selected in such a way that the ratio of *D* to *A* is 1:1 to 1:4.

10. P-doped contact (1) according to any of the preceding claims, **characterized in that** the p-injectors (5) are disposed on the second surface (B) of the p-contact layer (2) in a regular pattern.

11. Light-emitting diode, comprising a radiation zone disposed between a n-doped contact and a p-doped contact (1) according to any of the claims 1 to 10.

12. Light-emitting diode according to claim 11, wherein the light-emitting diode emits light in the UV range of 200 nm to 400 nm, preferably in the UV-A range, UV-B range and/or UV-C range.

## Revendications

1. Contact dopé p (1) destiné à être utilisé dans une électrode électroluminescente pour le domaine spectral ultraviolet, comprenant une couche de contact p (2) consistant en p-AlGaN, ou le contenant, avec une première surface (A) pour l'établissement d'un contact avec une zone de rayonnement et une deuxième surface (B) comprenant, sur le côté opposé à la première surface (A) :
a) un revêtement (8) qui établit un contact direct avec 75%-96% de la deuxième surface (B) de la couche de contact p (2), et qui consiste en un matériau, ou le contient, qui présente une réflectivité maximale d'au moins 60% pour une lumière dans le domaine UV ayant une longueur d'onde de 200 nm à 400 nm ;
et
b) une pluralité d'injecteurs p (5) qui sont disposés directement sur la deuxième surface (B) de la couche de contact p (2) ;
les injecteurs p (5) comprenant une couche métallique d'injecteur p (6) qui permet d'établir une liaison ohmique entre la couche de contact p (2) et une source de courant et qui consiste en Au, Ni, Pd, Pt, Rh, Ti, Ni/Au, Pd/Ti/Au, Pd/Pt/Au ou Pt/Ti/Au, ou le contient, ainsi qu'une autre couche d'injecteur p (7) qui consiste en p-GaN ou en p-(In)GaN, ou le contient.

2. Contact dopé p (1) selon l'une des revendications précédentes, **caractérisé en ce que** le revêtement (8) est électriquement conducteur.

3. Contact dopé p (1) selon l'une des revendications précédentes, **caractérisé en ce que** le revêtement (8) consiste en Al ou le contient.

4. Contact dopé p (1) selon l'une des revendications précédentes, **caractérisé en ce que** la couche de contact p (2) comprend une ou plusieurs couches semiconductrices différentes.

5. Contact dopé p (1) selon l'une des revendications précédentes, **caractérisé en ce que** la couche semi-conductrice, qui forme la deuxième surface (B) de la couche de contact p (2) et sur laquelle sont appliqués directement les injecteurs p, consiste en AlGaN dopé p ou le comprend.

6. Contact dopé p (1) selon l'une des revendications précédentes, **caractérisé en ce que** les injecteurs p (5) présentent une largeur maximale *D* de 10 nm à 50 µm.

7. Contact dopé p (1) selon l'une des revendications précédentes, **caractérisé en ce que** les injecteurs p (5) sont à une distance *A* de 20 nm à 20 µm de leurs injecteurs p (5) respectivement adjacents.

8. Contact dopé p (1) selon l'une des revendications précédentes, **caractérisé en ce que** les distances *A* des injecteurs p (5) de leurs injecteurs p (5) adjacents sont égales pour tous les injecteurs p (5).

9. Contact dopé p (1) selon l'une des revendications précédentes, **caractérisé en ce que** *D* et *A* sont choisis de telle manière que le rapport de *D* à *A* est de 1 : 1 à 1 : 4.

10. Contact dopé p (1) selon l'une des revendications précédentes, **caractérisé en ce que** les injecteurs p (5) sont disposés sur la deuxième surface (B) de la couche de contact p (2) selon un motif régulier.

11. Électrode électroluminescente, comprenant une zone de rayonnement qui est disposée entre un contact dopé n et un contact dopé p (1) selon l'une des revendications 1 à 10.

12. Électrode électroluminescente selon la revendication 11, l'électrode électroluminescente émettant de la lumière dans le domaine UV de 200 nm à 400 nm, de préférence, dans le domaine UV-A, UV-B et/ou UV-C.
